# FASCICULE DE BREVET EUROPEEN

(11) **EP 1 014 761 B1**
(45) Date de publication et mention de la délivrance du brevet: **16.06.2004**
(21) Numéro de dépôt: 99403022.9
(22) Date de dépôt: 03.12.1999
(51) Int. Cl.: H05H 1/46, H01J 37/32

(54) **Elément de canalisation pour dispositif de traitement de gaz et dispositif incorporant un tel élément de canalisation**
Kanalelement für Gasbehandlungsvorrichtung und Vorrichtung die ein solches Kanalelement enthält
Duct piece for gas treatment device and device comprising such a duct piece

(30) Priorité: 22.12.1998 FR 9816246
(43) Date de publication de la demande: 28.06.2000
(73) Titulaire: L'air Liquide, S.A. à Directoire et Conseil de Surveillance pour l'Etude et l'Exploitation des Procédés Georges Claude, 75321 Paris Cedex 07 (FR)
(72) Inventeur: Rostaing, Jean-Christophe, 75321 Paris cedex 07 (FR); Moisan, Michel, Outremont, Q.C. H2V 2Z1 (CA); Etemadi, Roxane, 95100 Argenteuil (FR); Guerin, Daniel, 75321 Paris cedex 07 (FR)
(74) Mandataire: Vesin, Jacques

(56) Documents cités:
- EP-A- 0 874 537
- DE-A- 3 144 857
- FR-A- 2 595 876
- PATENT ABSTRACTS OF JAPAN vol. 096, no. 010, 31 octobre 1996 (1996-10-31) & JP 08 158073 A (ROHM CO LTD), 18 juin 1996 (1996-06-18)
- PATENT ABSTRACTS OF JAPAN vol. 005, no. 186 (E-084), 25 novembre 1981 (1981-11-25) & JP 56 111283 A (MATSUSHITA ELECTRIC IND CO LTD), 2 septembre 1981 (1981-09-02)

## Description

La présente invention est relative à un élément de canalisation pour dispositif de traitement de gaz dans lequel le gaz est excité par un plasma d'onde de surface, en particulier à pression atmosphérique.

Un type connu de dispositif excitateur efficace pour cette application est connu sous l'appellation "surfaguide" (voir par exemple EP-0 874 537-A).

Ce type de dispositif comporte une structure creuse formant guide d'ondes en matériau électriquement conducteur, destinée à être raccordée à un générateur de micro-ondes et munie d'un passage traversé par une canalisation en matériau diélectrique dans lequel circule le gaz à exciter et d'une zone de concentration du rayonnement micro-ondes produit par le générateur vers la canalisation en vue de produire, lors du fonctionnement du dispositif, un plasma d'onde de surface dans le gaz.

Un exemple d'application particulièrement intéressante de ce type de dispositif est le traitement par plasma d'un gaz chimiquement non réactif contenant des impuretés constituées de composés gazeux perfluorés à effet de serre.

Il permet en particulier de placer le gaz à traiter et les impuretés qu'il contient dans un champ électrique suffisamment intense pour réaliser une décharge électrique par ionisation des molécules de gaz, provoquée par l'arrachement d'électrons des molécules du gaz initialement neutres.

Sous l'action de la décharge, les molécules du gaz de fond, c'est-à-dire du gaz à purifier, sont dissociées pour former des radicaux de taille plus petite que les molécules initiales et, par suite, le cas échéant, des atomes individuels, ces atomes et fragments de molécules ainsi excités ne donnant lieu à sensiblement aucune réaction chimique.

Après passage dans la décharge, les atomes ou molécules de gaz de fond se désexcitent et se recombinent respectivement, pour se retrouver intacts en sortie.

Au contraire, les impuretés subissent par excitation une dissociation et une transformation irréversibles par formation de nouveaux fragments moléculaires ayant des propriétés chimiques différentes de celles des molécules initiales, qui sont dès lors susceptibles d'être extraites du gaz par un traitement ultérieur approprié.

Ce type de technique permet de traiter efficacement des débits importants de gaz. Elle présente toutefois une fiabilité relativement médiocre en raison du fait que le milieu gazeux présent au niveau de la décharge comporte une concentration relativement élevée en espèces radicalaires fluorées de haute énergie qui rendent ce dernier particulièrement agressif vis à vis de la paroi de la canalisation dans laquelle est établi le plasma.

Par exemple, lorsqu'on utilise une canalisation constituée d'un tube en silice ayant une épaisseur de 1 mm ce dernier peut être percé en moins de dix minutes au niveau de la zone de concentration du rayonnement micro-ondes incident, dans laquelle la densité de puissance micro-ondes est maximale.

En outre, lorsque l'on utilise de l'azote comme gaz plasmagène, gaz très difficile à ioniser et engendrant des plasmas particulièrement chauds, l'échauffement du tube au niveau de la zone de concentration du rayonnement provoque généralement sa fusion, même en l'absence de composé fluoré, et ce, relativement rapidement.

Enfin, au cours du fonctionnement, le tube en silice subit des sollicitations thermomécaniques très sévères, susceptibles d'entraîner l'apparition de fissures.

Le but de l'invention est de pallier les inconvénients précités, d'une part, en réduisant l'attaque de la canalisation dans laquelle est entretenue la décharge et, d'autre part, en permettant le maintien du fonctionnement normal du dispositif même après l'apparition d'une fissure dans la paroi au contact du plasma.

Elle a donc pour objet un élément de canalisation pour dispositif de traitement de gaz par excitation de ce dernier au moyen d'un rayonnement micro-ondes incident adapté pour produire dans le gaz un plasma d'onde de surface, l'élément de canalisation comprenant un tube à décharge en matériau diélectrique destiné à traverser le dispositif dans une zone de concentration du rayonnement incident, et dans lequel le gaz à exciter est destiné à circuler, caractérisé en ce que le tube comporte, sur une partie au moins de sa longueur une double paroi, les parois étant situées en relation d'échange thermique.

On améliore ainsi la résistance du tube à décharge tout en conservant une évacuation efficace de la chaleur dégagée par le plasma.

Dans différents modes de réalisation, l'élément de canalisation suivant l'invention peut en outre comporter une ou plusieurs des caractéristiques suivantes, prises isolément ou selon toutes les combinaisons techniquement possibles :
- l'espace entre les parois interne et externe du tube est empli d'un matériau diélectrique conducteur de la chaleur et relativement insensible aux espèces chimiques en provenance du plasma.

Ainsi, même après l'apparition d'une fissure dans la paroi interne du tube à décharge, les espèces susceptibles de migrer à travers la fissure sont stoppées par la couche de matière disposée entre les parois du tube.
- le matériau emplissant l'espace entre les parois interne et externe comporte du nitrure de bore;
- au niveau d'une partie destinée à être placée dans la zone de concentration du rayonnement incident, la paroi interne du tube à décharge comporte du saphir;
- de part et d'autre de la partie destinée à être placée dans la zone de concentration du rayonnement incident, la paroi interne du tube à décharge comporte une céramique ;
- la céramique est une céramique à base de nitrure d'aluminium ou d'alumine;
- paroi interne du tube à décharge est réalisée en une céramique à base de nitrure d'aluminium ;
- la paroi externe du tube à décharge est réalisé en une céramique à base de nitrure d'aluminium ;
- la paroi externe du tube à décharge comporte de la silice ;
- le tube interne est réalisé par empilement de tronçons de tube munis d'extrémités de forme complémentaire ;
- il comporte en outre un deuxième tube en matériau diélectrique de gainage d'un fluide de refroidissement, dans lequel est monté le tube à décharge et délimitant avec la paroi externe de ce dernier une chambre de refroidissement du tube à décharge destinée à être raccordée à une source de fluide diélectrique caloporteur de refroidissement ;
- le fluide de refroidissement comporte une polyalphaolefine isoparaffinique ;
- il comporte des moyens de montage à coulissement du tube de gainage du fluide de refroidissement autour du tube à décharge de manière à autoriser une dilatation de ces derniers ;
- les moyens de montage des tubes comportent au moins un support muni d'un passage interne étagé pour le passage d'une des zones d'extrémité de chaque tube, le passage comportant un premier alésage d'extrémité dans lequel est monté un organe de maintien d'une extrémité du tube à décharge et d'un raccord assurant l'alimentation du tube à décharge en gaz à traiter, un alésage médian traversé par le tube à décharge et un deuxième alésage d'extrémité dans lequel est emmanché le tube de gainage avec interposition d'un joint torique d'étanchéité
- le raccord constitue une tête coiffant l'extrémité du tube à décharge et comporte un filetage coopérant avec un filetage complémentaire ménagé dans l'organe de maintien ;
- il comporte en outre un deuxième joint d'étanchéité interposé entre l'organe de maintien et le raccord ;
- le support est équipé d'un canal d'alimentation du tube de gainage en fluide de refroidissement débouchant dans l'alésage interne, et est en outre muni d'une membrane d'étanchéité rapportée coiffant le support et l'organe de maintien ; et
- l'élément de canalisation comporte des moyens de blocage en rotation de l'organe de maintien dans le support.

L'invention a également pour objet un dispositif d'excitation d'un gaz, du type surfaguide, comprenant une structure creuse formant guide d'ondes en matériau électriquement conducteur, destinée à être raccordée à un générateur de micro-ondes et munie d'un passage traversé par une canalisation en matériau diélectrique dans lequel circule le gaz à exciter et d'une zone de concentration du rayonnement micro-ondes produit par le générateur vers la canalisation en vue de produire, lors du fonctionnement du dispositif, un plasma d'onde de surface dans le gaz, caractérisé en ce que la canalisation comporte un élément de canalisation tel que défini ci-dessus.

D'autres caractéristiques et avantages ressortiront de la description suivante, donnée uniquement à titre d'exemple et faite en référence aux dessins annexés sur lesquels
- la Fig. 1 est une vue schématique en perspective d'un surfaguide utilisant un élément de canalisation suivant l'invention ;
- la Fig. 2 est une vue en coupe longitudinale à plus grande échelle d'un premier exemple de réalisation d'un élément de canalisation suivant l'invention ;
- les Fig. 3 à 5 illustrent, de façon schématique, des modes de réalisation respectifs de l'élément de canalisation selon l'invention
- les Fig. 6 à 8 illustrent, de façon schématique, différents modes d'assemblage de l'élément de canalisation selon l'invention ; et
- la Fig. 9 est une vue en coupe longitudinale d'une zone d'extrémité de l'élément de canalisation suivant l'invention.

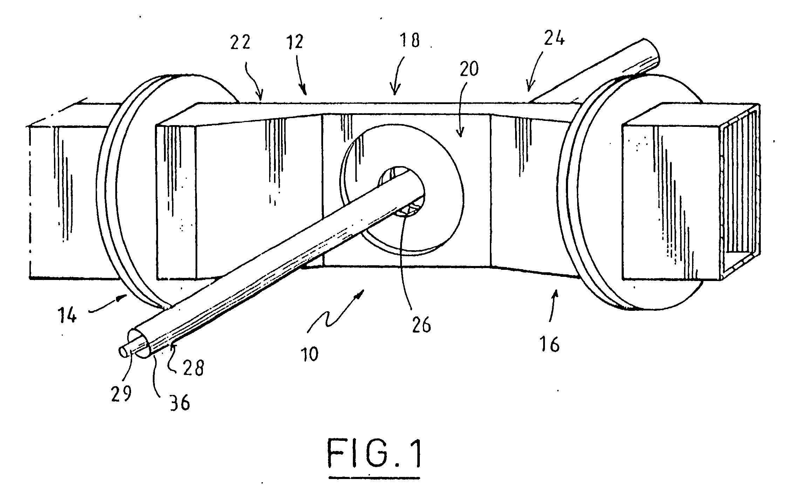

Sur la Fig. 1 on a représenté une vue schématique en perspective d'un surfaguide, désigné par la référence numérique générale 10.

Le surfaguide 10 est constitué principalement d'une structure creuse 12 de forme longitudinale réalisée en un matériau électriquement conducteur approprié pour l'utilisation envisagée, en particulier un métal.

La structure creuse 12 a de préférence une section transversale parallélépipèdique et comporte deux extrémités ouvertes, respectivement 14 et 16, destinée l'une à être raccordée à un générateur de micro-ondes et l'autre à des moyens appropriés pour former un court-circuit, de préférence une plaque conductrice disposée transversalement et réglable longitudinalement (non représentés) .

Entre les deux zones d'extrémité 14 et 16, la structure 12 comporte une zone 18 de section rétrécie comportant une partie médiane 20 de section constante s'étendant entre deux parties 22 et 24 de section linéairement croissante en direction des zones d'extrémité 14 et 16.

Les parois constitutives de la partie médiane 20, qui constitue une zone de concentration du rayonnement micro-ondes incident, sont équipées chacune d'un orifice tel que 26, ces orifices formant un passage pour un élément de canalisation 28 réalisé, comme cela sera décrit en détail par la suite, à partir de matériaux diélectriques appropriés.

L'élément de canalisation 28, fictivement tronqué sur cette Fig. 1 et schématiquement représenté, comporte un tube à décharge 29 dans lequel circule une colonne de gaz à exciter et dans lequel est crée le plasma sous l'action du rayonnement micro-ondes produit par le générateur.

Une application du surfaguide, représenté sur la figure 1, est l'épuration de Krypton et du Xénon par destruction de molécules d'impuretés, telles que le CF₄ ou le CH₄, en convertissant ces impuretés en composés gazeux réactifs susceptibles d'être traités par action de composés réactifs correspondants, après passage dans la décharge.

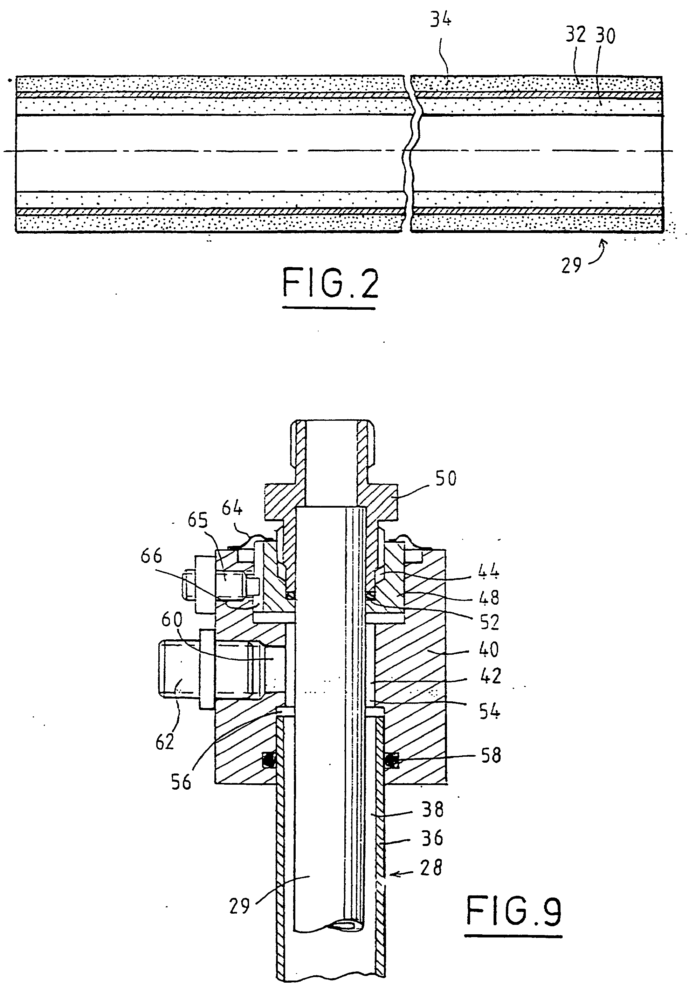

Comme on le voit sur la figure 2, et conformément à l'invention, le tube à décharge 29 comporte une double paroi, à savoir une paroi interne 30 et une paroi externe 32, s'étendant sur au moins une partie de sa longueur et destinée à être placée au niveau de la zone de concentration du rayonnement incident dans laquelle est entretenue la décharge.

Dans l'exemple de réalisation représenté, le tube à décharge 29 comporte une double paroi s'étendant sur toute sa longueur.

Pour ce faire, le tube à décharge 29 est constitué par l'association de deux tubes, l'un interne 30 constitutif de la paroi interne et l'autre externe 32 constitutif de la paroi externe, disposés de façon coaxiale et de diamètre approprié pour délimiter entre eux un espace généralement cylindrique 34 relativement étroit, de référence inférieure à 1 mm.

Afin d'être utilisable dans le cadre de l'application envisagée, c'est à dire de résister aux espèces chimiques engendrées dans la décharge et aux sollicitations thermiques auxquelles est soumis le tube 29, ce dernier doit notamment présenter les propriétés suivantes :

Tout d'abord, il ne doit pas être attaqué de façon sensible dans un milieu de plasma fluoré de haute densité, en particulier lorsque le gaz de fond est de l'air ou de l'azote.

D'autre part, il doit présenter d'excellentes propriétés thermomécaniques afin d'éviter toute fissuration à travers l'épaisseur de sa paroi ce qui offrirait un passage pour les espèces du gaz, alors que, comme cela sera mentionné par la suite, sa surface interne peut être portée à une température de l'ordre de 800°C alors que sa surface externe est refroidie à une température inférieure à 100°C.

Il doit présenter une conductivité thermique très élevée afin de permettre une évacuation rapide de la chaleur produite par le plasma.

Enfin, les pertes diélectriques à la fréquence du rayonnement micro-ondes incident doivent être très faibles et ce sur une gamme de température allant de la température ambiante jusqu'à plusieurs centaines de degrés Celsius. Plus précisément, la tangente de pertes diélectriques devrait être inférieure, typiquement, à 10⁻³ sur toute la gamme de températures envisagées.

Pour atteindre ces objectifs, selon un premier exemple de réalisation, représenté à la Fig. 2, la paroi interne 30 du tube à décharge 28 est réalisée à partir d'un matériau relativement inerte aux espèces chimiques fluorées du plasma, présentant une bonne conductivité thermique et des pertes diélectriques très faibles jusqu'à des températures très élevées, à savoir du saphir. Ce matériau présente toutefois des propriétés thermomécaniques relativement mauvaises et tend à se fissurer.

Pour pallier cet inconvénient, la paroi externe 32 du tube à décharge est réalisée en un matériau possédant d'excellentes propriétés mécaniques, c'est-à-dire ne présentant pratiquement aucun risque de fissuration ou de rupture, de préférence, de la silice. Cependant, en cas de fissuration de la paroi interne 30, des espèces gazeuses issues du plasma pourraient migrer à travers la fissure et venir au contact de la paroi externe 32. L'attaque chimique de cette dernière qui en résulterait serait moins rapide que pour une paroi de silice au contact direct du plasma, mais elle serait malgré tout inacceptable pour une utilisation de très longue durée sans entretien ni remplacement.

Afin d'assurer la tenue thermomécanique du tube 28, l'espace interstitiel entre les parois interne 30 et externe 32 est empli d'un matériau diélectrique bon conducteur thermique présentant de très bonnes propriétés thermomécaniques et résistant en milieu oxydant et/ou fluoré lorsque l'énergie des espèces chimiques n'est pas trop élevée, en l'espèce du nitrure de bore.

De préférence, afin d'emplir aisément l'espace 34, le nitrure de bore est utilisé sous une forme liquide et mis en forme par durcissement à la chaleur, comme le "Boron Nitride Coating COMBAT type A" de "Carborundum".

En variante, il est possible de réaliser la paroi interne 30 du tube à décharge 28 en une céramique usinable à base de nitrure d'aluminium, matériau très résistant au plasma d'azote fluoré, présentant d'excellentes propriétés thermomécaniques et n'absorbant sensiblement pas à une fréquence de 2,45 GHz, c'est à dire suffisamment peu pour ne pas être dégradée.

Par exemple, cette matière céramique est constituée de "Shapal™-M Soft". Tokuyama corp, TOKYO. Ce matériau présente en outre l'avantage de pouvoir être usiné avec facilité et à un coût acceptable et permet donc de réaliser des pièces tubulaires ayant des cotes très précises.

Il est ainsi possible, avec un tel matériau, d'obtenir un ajustement relativement jointif entre les tubes interne et externe. Si l'épaisseur du film d'air résiduel entre les deux tubes ne dépasse pas quelques centièmes de millimètres, la conductivité thermique, bien que non nécessairement très uniforme, est suffisante pour permettre une bonne évacuation de la chaleur. Dans ce cas, la couche de matériaux diélectriques emplissant l'espace interstitiel entre les parois interne 30 et externe 32 peut être supprimée.

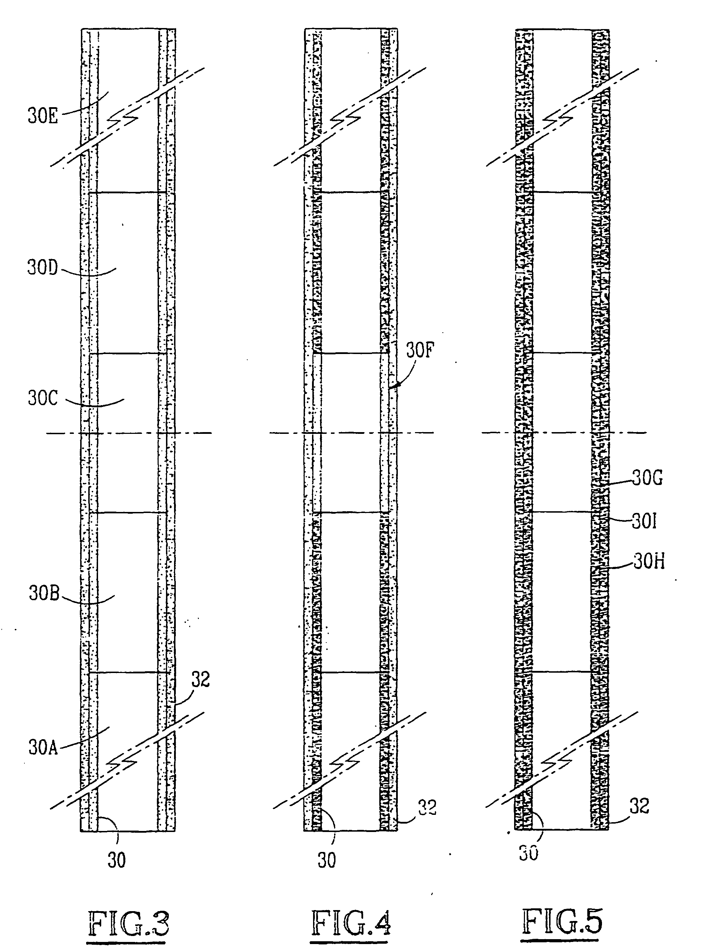

Différents modes de réalisation de l'élément de canalisation selon l'invention vont maintenant être décrits en référence aux Fig. 3 à 6.

Le mode de réalisation représenté sur la Fig. 3 correspond à l'exemple de réalisation de la Fig. 2 dans lequel le tube interne 30 est réalisé en saphir ou en "Shapal™" et le tube externe 32 est réalisé en silice. L'espace interstitiel entre les tubes interne et externe (non représenté) peut être rempli de nitrure de bore sans que cela ne soit nécessaire.

On voit sur cette Fig. 3 que le tube interne 30 est réalisé par assemblage de tronçons cylindriques 30-A, 30-B, 30-C, 30-D et 30-E empilés, du nitrure de bore étant appliqué entre les jointures de manière à les obturer et faire barrière à la migration des espèces fluorées vers la silice. Cette application peut se faire, par exemple, sur l'extrémité inférieure de chaque tronçon avant de l'introduire dans le tube de silice pour l'inclure dans l'empilement.

Comme cela a été mentionné précédemment, afin de limiter les coûts de fabrication, il est possible de doter le tube à décharge 28 d'un tube interne 30 sur une longueur limitée correspondant sensiblement à la zone dans laquelle le plasma est créé.

Il est également possible, selon un mode de réalisation particulier représenté à la Fig. 4, de doter le tube à décharge 28 d'une paroi interne 30 comportant un tronçon médian 30-F en saphir destiné à être placé dans la zone de concentration du rayonnement incident, c'est à dire dans la zone dans laquelle le plasma a une densité maximale, ce tronçon 30-F étant prolongé, de part et d'autre de cette zone, d'une portion de tube réalisé en céramique, par exemple de l'alumine frittée, ou, de préférence en "Shapal™".

Bien entendu, comme mentionné précédemment, il est nécessaire de prévoir un contact relativement étroit entre chaque zone de jonction afin d'empêcher que des espèces fluorées de haute énergie puissent migrer vers l'espace 34 et vers le tube externe 32.

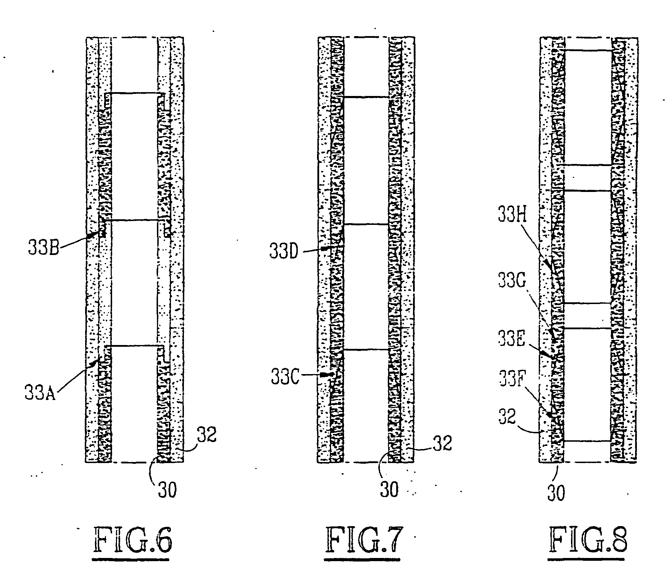

On a représenté sur la Fig. 5 un autre exemple de réalisation de l'élément de canalisation conforme à l'invention dans lequel le tube interne 30 et le tube externe 32 sont réalisés tous deux par assemblage de tronçons tubulaires en "Shapal™" empilés les uns sur les autres et collés avec du nitrure de bore de telle sorte que chaque zone de jonction entre deux tronçons 30-G et 30-H du tube interne 30 soit recouvert par un tronçon 30-I du tube externe 32. Un tube externe de maintien de l'assemblage de l'ensemble, en silice, peut être prévu.

On notera que le mode de réalisation représenté sur la Fig. 4, dans lequel un tronçon médian 30-F en saphir est situé dans l'interstice de lancement présente une fiabilité maximale dans la mesure où l'absorption de la puissance micro-onde par le tube reste négligeable dans cette région du tube et où, dans cette zone, le plasma reste relativement centré sur l'axe du tube quelles que soient les conditions de fonctionnement et ne vient donc pas se coller contre la paroi interne du tube.

Les exemples de réalisation utilisant du "Shapal™" sont avantageux dans la mesure où ce matériau est un des plus résistants au plasma d'azote fluoré. Ce matériau est donc particulièrement avantageux pour gainer intérieurement le tube externe en silice dans une zone où le plasma est susceptible de se décentrer et d'entrer en contact avec la paroi, c'est à dire de part et d'autre de la zone correspondante à l'interstice de lancement.

Différents modes d'assemblage de l'élément de canalisation décrit précédemment vont maintenant être exposés en référence aux Fig. 6 à 9.

En se référant tout d'abord à la Fig. 6, un premier mode d'assemblage des tronçons consiste à configurer chaque tronçon constitutif du tube interne 30 sous la forme de tronçons tubulaires munis d'extrémités 33-A et 33-B délimitant l'une, 33-A, un alésage cylindrique et l'autre, 33-B, une jupe cylindrique, les autres tronçons étant munis d'extrémités complémentaires conformées de manière à venir s'emboîter par complémentarité de forme.

On notera que ce mode d'assemblage convient pour l'assemblage des tronçons réalisées en "Shapal™" ou, dans une moindre mesure, en saphir, l'usinage étant, dans ce cas, plus difficile à réaliser.

On notera également que, comme mentionné précédemment, du nitrure de bore est appliqué dans les jointures pour former une barrière empêchant la migration des espèces fluorées vers la silice externe.

D'autres modes d'assemblage, illustrés aux Fig. 7 et 8 sont envisageable pour l'assemblage de tronçons en "Shapal™".

On voit en effet sur ces figures que les tronçons constitutifs du tube interne 30 peuvent être configurés sous la forme de tronçons tubulaires munis d'extrémités 33-C et 33-D tronconiques.

Par exemple, l'une des extrémités 33-C est une extrémité tronconique femelle, l'autre extrémité 33-D étant une extrémité tronconique mâle (Fig. 7).

En variante, les deux extrémités 33-E et 33-F de l'un des tronçons sont des extrémités tronconiques mâles, les deux extrémités 33-G et 33-H du tronçon adjacent étant des extrémités tronconiques femelles (Fig. 8).

Comme cela a été mentionné précédemment, le tube à décharge 29 est en outre refroidi de façon à abaisser la température de sa surface externe jusqu'à une température voisine de 100°C.

Pour ce faire, et comme on le voit sur les Fig.1 et 9, l'élément de canalisation 28 comporte en outre un deuxième tube 36 en matériau diélectrique, par exemple de la silice, assurant un gainage d'un fluide de refroidissement et dans lequel est monté le tube à décharge 29.

Comme on le voit sur la Fig. 9, le tube de gainage 36 et le tube à décharge 28 délimitent entre eux une. chambre 38 de refroidissement du tube à décharge 29, de forme sensiblement cylindrique, et destinée à être raccordée à une source de fluide caloporteur de refroidissement (non représentée), constituée par exemple par une polyalphaoléfine isoparaffinique (PAO), comme celle vendue par LUBRI DELTA INC, Laval, QUEBEC, matériaux classiquement utilisés comme fluide dans des circuits hydrauliques, et présentant de bonnes propriétés caloporteuses tout en étant un très bon diélectrique.

Enfin, et comme cela est visible sur la Fig.9, l'élément de canalisation est doté de moyens de montage à coulissement du tube à décharge 29 dans le tube de gainage 36 de manière à autoriser une dilatation de ces derniers l'un par rapport à l'autre au cours du fonctionnement du dispositif 10.

Comme on le voit sur cette figure, les moyens de montage des tubes comportent un support 40 réalisé à partir d'un bloc de métal ou de polymère approprié muni d'un passage interne 42 étagé pour le passage d'une zone d'extrémité correspondante de chaque tube 29 et 36.

Le passage 42 comporte un premier alésage d'extrémité 44 dans lequel est monté, à coulissement, un organe 48 assurant le maintien d'une extrémité du tube à décharge 29 et d'un raccord d'extrémité 50 assurant l'alimentation du tube à décharge 29 en gaz à traiter.

Plus particulièrement, le raccord 50 constitue une tête venant coiffer l'extrémité libre du tube à décharge 29 et munie d'un filetage externe coopérant avec un filetage interne complémentaire ménagé dans l'organe de maintien 48, un joint torique d'étanchéité 52 étant prévu dans le fond de l'organe de maintien 48 sur lequel vient reposer le raccord 50.

Par ailleurs, le support 40 comporte un alésage médian 54 traversé par le tube à décharge 28 et un deuxième alésage d'extrémité 56 opposé au premier alésage 44 dans lequel est emmanché le tube de gainage 36, avec interposition d'un joint torique d'étanchéité 58 et de maintien par friction du tube 36.

On voit enfin sur la Fig. 9 que le support 40 est en outre muni d'un canal d'alimentation 60 doté d'un raccord 62 en communication avec une source d'alimentation en fluide de refroidissement, ce canal 60 débouchant dans l'alésage interne afin d'alimenter la chambre 38 en fluide de refroidissement.

Une membrane d'étanchéité 64 rapportée, de préférence collée, coiffe le support 40 et l'organe de maintien 48 afin d'éviter toute fuite du fluide de refroidissement.

Une clavette 65, portée par le support 40, coopère avec une cannelure 66 ménagée dans l'organe de maintien 48 afin de bloquer en rotation l'organe 48 dans le support 40 afin d'éviter que, lors du montage, la membrane ne se détériore sous l'effet du couple de serrage appliqué sur le raccord 50.

On notera qu'un assemblage sensiblement identique est prévu à l'autre extrémité du tube à décharge pour l'extraction du fluide caloporteur et la collecte des gaz après traitement par le plasma.

Cet assemblage, qui permet au tube à décharge 29 et au tube de gainage 36 de se dilater librement, évite l'apparition de sollicitations thermomécaniques trop sévères lorsque le plasma est allumé, tout en autorisant une circulation efficace du fluide de refroidissement dans la chambre 38.

On conçoit que l'invention qui vient d'être décrite, utilisant un tube à décharge composite muni d'une paroi interne relativement insensible aux espèces fluorées présentes dans la décharge, ayant, d'une part, une conductivité thermique permettant une évacuation rapide de la chaleur produite par le plasma et des pertes diélectriques relativement faibles en raison de la présence d'un tube interne comportant du saphir, et, d'autre part, des propriétés thermomécaniques à un niveau élevé en raison de la relation d'échange thermique entre le tube externe et le tube interne permet de limiter considérablement l'attaque du tube à décharge et d'empêcher ou limiter la défaillance thermomécanique de ces matériaux.

En outre dans le cas de l'utilisation d'un tube interne de saphir, même après l'apparition d'une fissure dans le tube interne, la présence de nitrure de bore emplissant l'espace interstitiel entre les parois interne et externe permet d'éviter toute migration d'espèces corrosives vers la paroi externe du tube, dans la mesure où il constitue une couche de passivation de la paroi externe du tube à décharge contre ces espèces.

Comme mentionné précédemment, une application du dispositif surfaguide décrit en référence à la figure 1 est l'épuration de Krypton et de Xénon, en vue de la destruction d'impuretés, telles que le CF₄ et CH₄.

Il peut être monté en sortie d'une installation de distillation pour l'extraction de ces composés ou alimenté à partir de bouteilles dans lesquelles sont stockés sous pression du Krypton, du Xénon ou un mélange de ces gaz.

Pour effectuer cette épuration, le surfaguide alimenté en micro-ondes permet de créer, à pression atmosphérique, un plasma qui est le siège d'excitations énergétiques électroniques très élevées, correspondant à des températures de plusieurs dizaines de milliers de Kelvin permettant ainsi, par collision électronique, d'exciter les atomes et molécules constitutifs du gaz, et en particulier de transformer les molécules d'impuretés, telles que CF₄ et CH₄, d'un état relativement stable chimiquement vers un état réactif ce qui permet ensuite de les éliminer soit à la suite de leur condensation immédiate et spontanée sous forme de dépôts ou de particules solides (polymères fluorocarbonés, noir de carbone...) soit en les faisant réagir avec un réactif solide ou liquide correspondant. On conçoit que les atomes et molécules du gaz à épurer sont également excitées dans la décharge, mais ils se désexcitent et/ou se recombinent immédiatement à la sortie de cette dernière et d'autre part ne réagissent pas avec les composés réactifs solides ou liquides sur lesquels circule ensuite le gaz à épurer.

Ainsi, par exemple, une puissance micro-onde incidente de 1500 W permet un traitement de 1,2 m³/h de Krypton éventuellement mélangé à de l'oxygène pour améliorer l'accomplissement du processus de transformation du CF₄ en espèces réactives.

Le mélange incident ainsi excité, après passage sur un élément alcalin tel que de la chaux sodée ne comporte sensiblement plus d'impuretés.

On conçoit que l'invention qui vient d'être décrite permet également de détruire de façon aussi efficace d'autres types d'impuretés, et de façon générale, les gaz perfluorés ou hydrofluorocarbonés.

Ainsi, il est possible, à l'aide d'un tel surfaguide, d'obtenir, par exemple, une destruction à environ 97% de C₂F₆ dans un mélange gazeux incident contenant 4,5% de C₂F₆ mélangé à de l'O₂ et du N₂, pour une puissance micro-onde incidente égale à 790 W.

L'invention est donc également applicable à l'épuration de tous les gaz, en général et notamment à la destruction des composés du type PFC (composés fluorés) et/ou CFC (composés du type chlorofluoro carbonés), notamment lorsque ceux-ci sont présents dans des effluents gazeux, notamment ceux issus des réacteurs de fabrication de semi-conducteurs ou autres réacteurs chimiques, produisant de tels produits à l'état pur ou de préférence dilués dans d'autres gaz et notamment l'azote, l'argon, l'hélium, les gaz inertes, l'oxygène, l'hydrogène et/ou le gaz carbonique, pris seuls ou en mélanges en toutes proportions.

## Revendications

1. Elément de canalisation (28) pour dispositif (10) de traitement de gaz par excitation de ce dernier au moyen d'un rayonnement micro-ondes incident adapté pour produire dans le gaz un plasma d'onde de surface, l'élément de canalisation comprenant un tube à décharge (29) en matériau diélectrique destiné à traverser le dispositif (10) dans une zone de concentration du rayonnement incident, et dans lequel le gaz à exciter est destiné à circuler, **caractérisé en ce que** le tube (29) comporte, sur une partie au moins de sa longueur, une double paroi, les parois étant situées en relation d'échange thermique, l'espace (34) entre les parois interne (30) et externe (32) du tube est empli d'un matériau diélectrique conducteur de la chaleur et relativement insensible aux espèces chimiques en provenance du plasma.

2. Elément de canalisation selon la revendication 1, **caractérisé en ce que** le matériau emplissant l'espace (34) entre les parois interne et externe comporte du nitrure de bore.

3. Elément de canalisation selon l'une quelconque des revendications 1 et 2, **caractérisé en ce que**, au niveau d'une partie destinée à être placée dans la zone de concentration du rayonnement incident, la paroi interne (30) du tube à décharge (29) comporte du saphir.

4. Elément de canalisation selon la revendication 3, **caractérisé en ce que**, de part et d'autre de la partie destinée à être placée dans la zone de concentration du rayonnement incident, la paroi interne (30) du tube à décharge (29) comporte une céramique.

5. Elément de canalisation selon la revendication 4, **caractérisé en ce que** la céramique est une céramique à base de nitrure d'aluminium ou d'alumine frittée.

6. Elément de canalisation selon l'une quelconque des revendications 1 à 2, **caractérisé en ce que** la paroi interne (30) du tube à décharge est réalisée en une céramique à base de nitrure d'aluminium.

7. Elément de canalisation selon la revendication 6, **caractérisé en ce que** la paroi externe (32) du tube à décharge est réalise en une céramique à base de nitrure d'aluminium.

8. Elément de canalisation selon l'une quelconque des revendications 1 à 6, **caractérisé en ce que** la paroi externe (32) du tube à décharge (29) comporte de la silice.

9. Elément de canalisation selon l'une quelconque des revendications 1 à 8, **caractérisé en ce que** le tube interne (30) est réalisé par empilement de tronçons de tube munis d'extrémités de forme complémentaire.

10. Elément de canalisation selon l'une quelconque des revendications 1 à 9, **caractérisé en ce qu'**il comporte en outre un deuxième tube (36) en matériau diélectrique de gainage d'un fluide de refroidissement, dans lequel est monté le tube à décharge (29) et délimitant avec la paroi externe de ce dernier une chambre ce refroidissement (38). du tube à décharge destinée à être raccordée à une source de fluide diélectrique caloporteur de refroidissement.

11. Elément de canalisation selon la revendication 10, **caractérisé en ce que** le fluide de refroidissement comporte une polyalphaolefine isoparaffinique.

12. Elément de canalisation selon l'une des revendications 10 et 11, **caractérisé en ce qu'**il comporte des moyens de montage (40, 44, 50) à coulissement du tube de gainage (36) du fluide de refroidissement autour du tube à décharge (29) de manière à autoriser une dilatation de ces derniers.

13. Elément de canalisation selon la revendication 12, **caractérisé en ce que** les moyens de montage des tubes comportent, au moins un support (40) muni d'un passage interne (42) étagé pour le passage d'une des zones d'extrémité de chaque tube, le passage (42) comportant un premier alésage d'extrémité (44) dans lequel est monté un organe (48) de maintien d'une extrémité du tube à décharge (29) et d'un raccord (50) assurant l'alimentation du tube à décharge (29) en gaz à traiter, un alésage médian (54) traversé par le tube à décharge (29) et un deuxième alésage d'extrémité (56) dans lequel est emmanché le tube de gainage (36) avec interposition d'un joint torique d'étanchéité (58).

14. Elément de canalisation selon la revendication 13, **caractérisé en ce que** le raccord (50) constitue une tête coiffant l'extrémité du tube à décharge (29), et comporte un filetage coopérant avec un filetage complémentaire ménagé dans l'organe de maintien (48).

15. Elément de canalisation selon la revendication 14, **caractérisé en ce qu'**il comporte en outre un deuxième joint d'étanchéité (52) interposé entre l'organe de maintien et le raccord.

16. Elément de canalisation selon l'une quelconque des revendications 13 à 15, **caractérisé en ce que** le support est en outre équipé d'un canal (60) d'alimentation du tube de gainage (36) en fluide de refroidissement débouchant dans l'alésage interne (54), et **en ce qu'**il est en outre muni d'une membrane d'étanchéité (64) rapportée coiffant le support (40) et l'organe de maintien (48).

17. Elément de canalisation selon la revendication 16, **caractérisé en ce qu'**il comporte des moyens de blocage en rotation de l'organe (48) de maintien dans le support (40).

18. Dispositif d'excitation d'un gaz, du type. surfaguide, comprenant une structure creuse (12) formant guide d'ondes en matériau électriquement conducteur, destinée à être raccordée à un générateur de micro-ondes et munie d'un passage traversé par une canalisation (28) en matériau diélectrique dans lequel circule le gaz à exciter et d'une zone (20) de concentration du rayonnement micro-ondes produit par le générateur vers la canalisation (28) en vue de produire, lors du fonctionnement du dispositif, un plasma d'onde de surface dans le gaz, **caractérisé en ce que** la canalisation (28) comporte un élément, de canalisation selon l'une quelconque des revendications 1 à 17.

19. Procédé d'épuration d'un gaz, **caractérisé en ce que** l'on utilise un dispositif selon la revendication 18.

## Claims

1. Section of pipe (28) for a device (10) for treating a gas by exciting the latter by means of incident microwave radiation suitable for producing a surface-wave plasma in the gas, the section of pipe including a discharge tube (29) made of dielectric material intended to pass through the device (10) in a region for concentrating the incident radiation, and through which the gas to be excited is intended to flow, **characterized in that** the tube (29) comprises, over at least part of its length, a double wall, the walls lying in a heat-exchange relationship, the space (34) between the inner (30) and outer (32) walls of the tube is filled with a thermally conductive dielectric material which is relatively insensitive to the chemical species coming from the plasma.

2. Section of pipe according to Claim 1, **characterized in that** the material filling the space (34) between the inner and outer walls comprises boron nitride.

3. Section of pipe according to either of Claims 1 and 2, **characterized in that** the inner wall (30) of the discharge tube (29) in a part intended to be placed in the region for concentrating the incident radiation comprises sapphire.

4. Section of pipe according to Claim 3, **characterized in that**, on either side of the part intended to be placed in the region for concentrating the incident radiation, the inner wall (30) of the discharge tube (29) comprises a ceramic.

5. Section of pipe according to Claim 4, **characterized in that** the ceramic is a ceramic based on aluminium nitride or on sintered alumina.

6. Section of pipe according to either one of Claims 1 and 2, **characterized in that** the inner wall (30) of the discharge tube is made of a ceramic based on aluminium nitride.

7. Section of pipe according to Claim 6, **characterized in that** the outer wall (32) of the discharge tube is made of a ceramic based on aluminium nitride.

8. Section of pipe according to any one of Claims 1 to 6, **characterized in that** the outer wall (32) of the discharge tube (29) comprises silica.

9. Section of pipe according to any one of Claims 1 to 8, **characterized in that** the inner tube (30) is made by stacking lengths of tube which are provided with ends of complementary shape.

10. Section of pipe according to any one of Claims 1 to 9, **characterized in that** it furthermore comprises a second tube (36) made of dielectric material for jacketing a cooling fluid, in which the discharge tube (29) is mounted, the second tube together with the outer wall of the latter defining a chamber (38) for cooling the discharge tube, this chamber being intended to be connected to a source of dielectric heat-transfer cooling fluid.

11. Section of pipe according to Claim 10, **characterized in that** the cooling fluid comprises an isoparaffinic polyalphaolefin.

12. Section of pipe according to either of Claims 10 and 11, **characterized in that** it comprises means (40, 44, 50) for mounting the cooling-fluid jacketing tube (36) around the discharge tube (29) in a sliding manner so as to allow these tubes to expand.

13. Section of pipe according to Claim 12, **characterized in that** the means for mounting the tubes comprise at least one support (40) provided with a stepped internal passage (42) into which one of the end regions of each tube passes, the passage (42) comprising a first end bore (44), in which a member (48) for holding one end of the discharge tube (29) and for holding a fitting (50) which ensures that the discharge tube (29) is supplied with gas to be treated is mounted, a central bore (54), through which the discharge tube (29) passes, and a second end bore (56), into which the jacketing tube (36) is fitted with interposition of a O-ring seal (58).

14. Section of pipe according to Claim 13, **characterized in that** the fitting (50) constitutes a head capping off the end of the discharge tube (29) and comprises a thread which engages with a complementary thread made in the holding member (48).

15. Section of pipe according to Claim 14, **characterized in that** it furthermore comprises a second seal (52) interposed between the holding member and the fitting.

16. Section of pipe according to any one of Claims 13 to 15, **characterized in that** the support is furthermore provided with a channel (60) for supplying the jacketing tube (36) with cooling fluid, this channel emerging in the internal bore (54), and **in that** it is furthermore provided with an added sealing membrane (64) covering the support (40) and the holding member (48).

17. Section of pipe according to Claim 16, **characterized in that** it comprises means for stopping the holding member (48) from rotating in the support (40) .

18. Device for exciting a gas, of the surface-waveguide type, having a hollow structure (12) forming a waveguide. made of electrically conductive material, which structure is intended to be connected to a microwave generator and is provided with a passage through which a pipe (28) made of dielectric material passes, in which the gas to be excited flows, and with a region (20) for concentrating the microwave radiation produced by the generator onto the pipe (28) for the purpose of producing, during operation of the device, a surface-wave plasma in the gas, **characterized in that** the pipe (28) comprises a section of pipe according to any one of Claims 1 to 17.

19. Process for purifying a gas, **characterized in that** a device according to Claim 18 is used.

## Patentansprüche

1. Kanalelement (28) für eine Gasbehandlungsvorrichtung (10) durch Erregung des Gases mittels einfallender Mikrowellenstrahlung, die dafür ausgelegt ist, in dem Gas ein Oberflächenwellenplasma zu erzeugen, wobei das Kanalelement ein Entladungsrohr (29) aus dielektrischem Material umfasst, das die Vorrichtung (10) in einem Konzentrationsbereich der einfallenden Strahlung durchqueren soll, und in dem das zu erregende Gas strömen soll, **dadurch gekennzeichnet, dass** das Rohr (29) an zumindest einem Teil seiner Länge eine Doppelwand aufweist, wobei der Raum (34) zwischen der Innenwand (30) und der Außenwand (32) des Rohrs mit einem dielektrischen, wärmeleitenden Material gefüllt ist, das vergleichsweise unempfindlich gegen im Plasma vorkommende chemische Spezies ist.

2. Kanalelement nach Anspruch 1, **dadurch gekennzeichnet, dass** das den Raum (34) zwischen der Innen- und der Außenwand ausfüllende Material Bornitrid beinhaltet.

3. Kanalelement nach einem der Ansprüche 1 und 2, **dadurch gekennzeichnet, dass** die Innenwand (30) des Entladungsrohrs (29) auf Höhe eines Abschnitts, der in dem Konzentrationsbereich der einfallenden Strahlung platziert werden soll, Saphir umfasst.

4. Kanalelement nach Anspruch 3, **dadurch gekennzeichnet, dass** die Innenwand (30) des Entladungsrohrs (29) auf beiden Seiten des Abschnitts, der in dem Konzentrationsbereich der einfallenden Strahlung platziert werden soll, Keramik umfasst.

5. Kanalelement nach Anspruch 4, **dadurch gekennzeichnet, dass** die Keramik eine Keramik auf Aluminiumnitridbasis. oder auf gesintertem Aluminiumoxid ist.

6. Kanalelement nach einem der Ansprüche 1 bis 2, **dadurch gekennzeichnet, dass** die Innenwand (30) des Entladungsrohrs aus einer Keramik auf Aluminiumnitridbasis hergestellt ist.

7. Kanalelement nach Anspruch 6, **dadurch gekennzeichnet, dass** die Außenwand (32) des Entladungsrohrs aus einer Keramik auf Aluminiumnitridbasis hergestellt ist.

8. Kanalelement nach einem der Ansprüche 1 bis 6, **dadurch gekennzeichnet, dass** die Außenwand (32) des Entladungsrohrs (29) Siliziumoxid beinhaltet.

9. Kanalelement nach einem der Ansprüche 1 bis 8, **dadurch gekennzeichnet, dass** das Innenrohr (30) durch Stapelung von Rohrabschnitten hergestellt ist, die mit Enden von komplementärer Form versehen sind.

10. Kanalelement nach einem der Ansprüche 1 bis 9, **dadurch gekennzeichnet, dass** es außerdem ein zweites Rohr (36) aus dielektrischem Material zur Umhüllung eines Kühlfluids umfasst, in dem das Entladungsrohr (29) angebracht ist und das mit der Außenwand des letzteren eine Kühlkammer (38) des Entladungsrohrs begrenzt, die an eine Quelle für Wärme transportierendes, dielektrisches Kühlfluid angeschlossen werden soll.

11. Kanalelement nach Anspruch 10, **dadurch gekennzeichnet, dass** das Kühlfluid ein Isoparaffin-Polyalphaolefin beinhaltet.

12. Kanalelement nach einem der Ansprüche 10 und 11, **dadurch gekennzeichnet, dass** es Mittel (40, 44, 50) zur gleitenden Montage des Hüllrohrs (36) des Kühlfluids um das Entladungsrohr (29) umfasst, um eine Dilatation dieser letzteren zu gestatten.

13. Kanalelement nach Anspruch 12, **dadurch gekennzeichnet, dass** die Monatgemittel des Rohres zumindest einen Träger (40) umfassen, der mit einem gestuften inneren Durchgang (42) für den Durchtritt von Endbereichen jedes Rohrs versehen ist, wobei der Durchgang , (42) eine erste Endbohrung (44) umfasst, in der ein Organ (48) zur Halterung eines Endes des Entladungsrohrs (29) und eines Anschlusses (50) angebracht ist, der für die Speisung des Entladungsrohrs (29) mit zu behandelndem Gas sorgt, eine Mittelbohrung (54), die von dem Entladungsrohr (29) durchquert wird, und eine zweite Endbohrung (56), in die das Hüllrohr (36) unter Einfügung einer ringförmigen Dichtung (58) eingesetzt ist.

14. Kanalelement nach Anspruch 13, **dadurch gekennzeichnet, dass** der Anschluss (50) einen Kopf bildet, der das Ende des Entladungsrohrs (29) bedeckt und ein Gewinde umfasst, das mit einem komplementären Gewinde zusammenwirkt, das in dem Halteorgan (48) ausgebildet ist.

15. Kanalelement nach Anspruch 14, **dadurch gekennzeichnet, dass** es außerdem eine zweite Dichtung (52) umfasst, die zwischen dem Halteorgan und dem Anschluss eingefügt ist.

16. Kanalelement nach einem der Ansprüche 13 bis 15, **dadurch gekennzeichnet, dass** der Träger außerdem mit einem Kanal (60) zur Speisung des Hüllrohrs (36) mit Kühlfluid versehen ist, der in die Innenbohrung (54) mündet, und dass es außerdem mit einem Membrandichtung (64) versehen ist, die an den Träger (40) und das Halteorgan (48) abdeckend angebracht ist.

17. Kanalelement nach Anspruch 16, **dadurch gekennzeichnet, dass** es Mittel zur Dreharretierung des Halteorgans (48) in dem Träger (40) umfasst.

18. Vorrichtung zur Erregung eines Gases der Oberflächenleiter-Art, die mit einer einen Wellenleiter bildenden, hohlen Struktur (12) aus elektrisch leitendem Material, die an einen Mikrowellengenerator angeschlossen werden soll und mit einem Durchgang, der von einem Kanal (28) aus dielektrischem Material durchquert wird, in dem das zu erregende Gas strömt, und einem Bereich (20) zur Konzentration der durch den Generator erzeugten Mikrowellenstrahlung auf den Kanal (28) versehen ist, um im Betrieb der Vorrichtung ein Oberflächenwellenplasma in dem Gas zu erzeugen, **dadurch gekennzeichnet, dass** der Kanal (28) ein Kanalelement nach einem der Ansprüche 1 bis 17 umfasst.

19. Verfahren zur Reinigung eines Gases, **dadurch gekennzeichnet, dass** man eine Vorrichtung nach Anspruch 18 einsetzt.
